Europäisches Patentamt

European Patent Office

Office européen des brevets

(11) Veröffentlichungsnummer: **0 403 436 B1**

(12) **EUROPÄISCHE PATENTSCHRIFT**

(45) Veröffentlichungstag der Patentschrift: **14.09.94**

(21) Anmeldenummer: **90810424.3**

(22) Anmeldetag: **11.06.90**

(51) Int. Cl.5: **G01R 31/28**, G01R 31/318, G06F 11/26

(54) **Anordnung zum Test digitaler Schaltungen mit konfigurierbaren, in den Test einbezogenen Takterzeugungsschaltungen.**

(30) Priorität: **13.06.89 DD 329515**

(43) Veröffentlichungstag der Anmeldung:
**19.12.90 Patentblatt 90/51**

(45) Bekanntmachung des Hinweises auf die
Patenterteilung:
**14.09.94 Patentblatt 94/37**

(84) Benannte Vertragsstaaten:
**AT CH DE FR GB IT LI NL**

(56) Entgegenhaltungen:
**US-A- 3 761 695**
**US-A- 3 783 254**
**US-A- 4 742 293**

(73) Patentinhaber: **Zentrum Mikroelektronik Dresden GmbH**
**Grenzstrasse 28**
**D-01109 Dresden (DE)**

(72) Erfinder: **Oehm, Jürgen, Dipl.-Physiker**
**Röthenbacher Strasse 5**
**DDR-8027 Dresden (DD)**
Erfinder: **Näther, Marcus, Dr. Ing.**
**Wilhelm-Koenen Platz 1**
**DDR-8036 Dresden (DD)**
Erfinder: **Grobelny, Lothar, Dipl.-Ing.**
**Uhlandstrasse 8**
**DDR-8010 Dresden (DD)**
Erfinder: **Hutschenreiter, Birgit, Dipl.-Math.**
**Hauptstrasse 76**
**DDR-8901 Schönau-Berzdorf (DD)**

(74) Vertreter: **Fischer, Franz Josef et al**
**BOVARD AG**
**Patentanwälte VSP**
**Optingenstrasse 16**
**CH-3000 Bern 25 (CH)**

EP 0 403 436 B1

EP 0 403 436 B1

**Beschreibung**

Die Erfindung betrifft eine Anordnung zum Test digitaler Schaltungen mit konfigurierbaren, in den Test einbezogenen Takterzeugungsschaltungen, welche vorzugsweise zur Pruefung komplexer digitaler Schaltkreise in LSI/VLSI-Technik zur Anwendung kommt, insbesondere wenn dabei mehrere voneinander verschiedene Taktsignale Verwendung finden.

Es ist allgemein bekannt, dass Flipflops komplexer digitaler Schaltungen modifiziert, i. e. funktionskonvertierbar ausgefuehrt werden, um sie zum Zwecke der besseren Testbarkeit der Schaltung zu Schieberegistern zusammenschalten zu koennen.

Diese Flipflops sind dann in unterschiedlichen Moden betreibbar. In einem "Anwendermodus" feuhren sie ihre normale Funktion aus. Unter Verwendung zusaetzlicher Hardware - die Ergaenzung um Schiebedateneingang und -ausgang sowie der Anschluss zweier zusaetzlicher externer Testtakte - wird in einem "Testmodus" die Schiebefunktion ermoeglicht.

Diese Loesung wird u. a. in den US-Patenten 3.761.695 und 3.783.254 dargelegt. Dabei ist eine komplizierte Ansteuerung erforderlich, damit sich die einzelnen Takte nicht ueberlappen und Wettlaufeffekte vermieden werden.

Bei Verwendung wettlauffreier Master-Slave-Flipflops genuegt der Anschluss nur eines zusaetzlichen Testtaktes (Williams, T. W.; Parker, K. P.: Design for testability - a survey". Proc. of the IEEE; Vol. 71; No. 1; Jan. 1983; S. 98 - 111).

Als Alternative hierzu wird der Anschluss eines externen Modussteuersignals anstelle des externen Testtaktes vorgeschlagen (Liu, D. L.; McCluskey, E. J.: "A CMOS cell library design for testability". VLSI Systems Design; 4. 5. 1987; S. 58 - 65). Hierbei fungiert der Takt des "Anwendermodus" bei Umschaltung ueber das Modussteuersignal im "Testmodus" als Testtakt.

Um die Verwendung mehrerer Takte und die Zusammenschaltung der Flipflops zu Schieberegistern in beliebiger Reihenfolge zu ermoeglichen, werden, gesteuert durch ein Modussteuersignal, im Testmodus alle Flipflops mit dem gleichen Takt betrieben.

Bei den bekannten Loesungen ergibt sich als Nachteil, dass alle Taktsignale direkt von einem Schaltkreispin eingespeist werden muessen. Sind mehrere Takte erforderlich, muessen dementsprechend mehrere voneinander unabhaengige Takte von mehreren Pins eingespeist werden. Die Verwendung voneinander abgeleiteter Taktsignale ist nicht moeglich.

Beim Einsatz des Schaltkreises ist, um das sich bei Verwendung mehrerer Takte ergebende Synchronisationsproblem zu beherrschen, eine korrekte Ansteuerung der einzelnen auf dem Chip voneinander unabhaengigen Takte von den Pins aus erforderlich.

Desweiteren ist bekannt, ein Modussteuersignal bei der Testung auf fuer die CMOS-Technik relevante Stuck-open-Fehler zu verwenden. Dazu werden spezielle Master-Slave-Flipflops eingesetzt, die neben dem Master einen Schiebe-und einen Arbeitsslave enthalten.

Im "Testmodus" realisiert das Modussteuersignal dei Konstanz des Arbeitsslaves, wodurch die Einstellung von Initialisierungswert und Testwert zur Testung der Stuck-open-Fehler ermoeglicht wird.

Im US-Patent 4.742.293 wird eine zum Test von CMOS-Schaltungen geeignete Latchanordnung vorgeschlagen, die neben dem "eigentlichen" Latch ein zusaetzliches Latch zur Zwischenspeicherung der Initialisierungswerte besitzt. Ueber einen Multiplexer und ein weiteres Steuersignal stimulieren diese beiden Latches die nachfolgende Schaltung.

Dabei durchlaufen aber Initialisierungswert und Testwert die vorgeschlagene Testanordnung auf verschiedenen Datenwegen. Somit koennen die Stuck-open-Fehler in der Latchanordnung selbst nicht getestet werden.

Das Ziel der Erfindung ist die Verbesserung der Integrierbarkeit digitaler System ueber die Verringerung des erforderlichen Hardwareaufwandes bei Erweiterung der schaltungstechnischen Moeglichkeiten sowie die Realisierung ihrer umfassenden Pruefung mit hoeherer Zeiteffektivitaet.

Der Erfindung liegt deshalb die Aufgabe zugrunde, eine Anordnung zum Test digitaler Schaltungen mit konfigurierbaren, in den Test einbezogenen Takterzeugungsschaltungen zu entwickeln, welche die Aufbereitung von Taktsignalen auf dem Chip ermoeglicht, so dass nicht mehr alle Taktsignale direkt ueber die Schaltkreispins eingespeist werden muessen, und den Test der Takterzeugungsschaltung nach den gleichen Prinzipien wie beim Test der uebrigen Schaltung relisiert, wobei der Entwurf der Schaltung nach Scanpath-Prinzipien zu gewaehrleisten ist.

In Loesung dieser Aufgabe kommt eine Anordnung zur Anwendung, welche Dateneingaenge und einen Schiebedateneingang, Datenausgaenge und einen Schiebedatenausgang sowie Takt- und Steuersignaleingaenge besitzt. Sie enthaelt eine Flipflopanordnung aus mindestens zwei und maximal drei getakteten, seriell verschalteten Latches. Dabei sind die Datenausgaenge der Latches jeweils auf den Dateneingang des

2

nachfolgenden Latches gelegt; dem Dateneingang des ersten Latches ist ein Multiplexer vorgeschaltet, dessen Dateneingaenge an den Dateneingaengen und dem Schiebedateneingang der Anordnung angeschlossen sind.

Erfindungsgemaess sind nun ein Schaltungstakt, ein Testtakt und ein Schaltungstaktunterdrueckungssignal auf die entsprechenden Eingaenge eines nichtlinearen, die genannten Signale logisch verknuepfenden Netzwerkes gefuehrt, an dessen Ausgang der generierte Steuertakt gelegt ist. Das Schaltungstaktunterdrueckungssignal ist weiterhin auf den Steuereingang des Multiplexers gefuehrt. Der Takteingang des ersten Latches ist negiert und der Takteingang des zweiten Latches ist nichtnegiert am vom nichtlinearen Netzwerk generierten Steuertakt angeschlossen. Der Takteingang des ggf. vorhandenen dritten Latches ist an das Schaltungstaktunterdrueckungssignal gelegt. Bestimmte Datenausgaenge der genannten Latches realisieren die Datenausgaenge und den Schiebedatenausgang der Anordnung.

Dabei ist der Schaltungstakt ein Takt, der durch eine konfigurierbare Takterzeugungsschaltung in der digitalen Schaltung abgeleitet werden kann. Testtakt sowie Schaltungstaktunterdrueckungssignal sind zu Testzwecken ergaenzte, ueber zwei zusaetzliche Pins eingespeiste unabhaengige Signale.

In einer ersten Ausgestaltungsvariante stellt die Flipflopanordnung ein scan-path-faehiges Master-Slave-Flipflop dar. Dazu enthaelt die Flipflopanordnung vorzugsweise zwei serielle verschaltete Latches; der Datenausgang und der Schiebedatenausgang der Anordnung sind am Datenausgang des zweiten Latches sowie der negierte Datenausgang der Anordnung am negierten Datenausgang des zweiten Latches angeschlossen.

In einer zweiten Ausgestaltungsvariante stellt die Flipflopanordnung ein scan-path-faehiges Master-Slave-Flipflop dar, das fuer den Test von Stuck-open-Fehlern aus gelegt ist. Dazu enthaelt die Flipflopanordnung vorzugsweise drei seriell verschaltete Latches; der Schiebedatenausgang der Anordnung ist am Datenausgang des zweiten Latches, der Datenausgang der Anordnung am Datenausgang des dritten Latches sowie der negierte Datenausgang der Anordnung am negierten Datenausgang des dritten Latches angeschlossen.

In einer dritten Ausgestaltungsvariante stellt die Flipflopanordnung eine scan-path-faehige Latchanordnung dar. Dazu enthaelt die Flipflopanordnung vorzugsweise zwei seriell verschaltete Latches; der Schiebedatenausgang der Anordnung ist am Datenausgang des zweiten Latches, der Datenausgang der Anordnung am Datenausgang des ersten Latches sowie der negierte Datenausgang der Anordnung am negierten Datenausgang des ersten Latches angeschlossen.

In einer vierten Ausgestaltungsvariante stellte die Flipflopanordnung eine scan-path-faehige Latchanordnung dar, die fuer den Test von Stuck-open-Fehlern ausgelegt ist. Dazu enthaelt die Flipflopanordnung vorzugsweise zwei seriell verschaltete Latches, wobei der Datenausgang des ersten Latches zusaetzlich auf den Dateneingang eines dritten Latches gefuehrt ist, dessen Takteingang am Schaltungstaktunterdrueckungssignal liegt. Der Schiebedatenausgang der Anordnung ist am Datenausgang des zweiten Latches, der Datenausgang der Anordnung am Datenausgang des dritten Latches sowie der negierte Datenausgang der Anordnung am negierten Datenausgang des dritten Latches angeschlossen.

Das genannte nichtlineare Netzwerk generiert in weiterer vorzugsweiser Ausgestaltung der Erfindung den Steuertakt aus der logischen UND-Verknuepfung des Schaltungstaktes mit dem Schaltungstaktunterdrueckungssignal sowie deren logischer ODER-Verknuepfung mit dem Testtakt.

In einer ersten Ausgestaltungsvariante des nichtlinearen Netzwerkes sind der Schaltungstakt ueber den zweiten Eingang des Netzwerkes auf den ersten und das Schaltungstaktunterdrueckungssignal ueber den ersten Eingang des Netzwerkes auf den zweiten Eingang eines UND-Gatters gefuehrt. Der Ausgang des UND-Gatters ist an den ersten und der ueber den dritten Eingang des Netzwerkes angeschlossene Testtakt ist an den zweiten Eingang eines ODER-Gatters gelegt, dessen Ausgang den Ausgang des Netzwerkes realisert.

In einer zweiten Ausgestaltungsvariante des nichtlinearen Netzwerkes sind der Testtakt ueber den dritten Eingang des Netzwerkes auf den ersten Eingang eines ODER-Gatters und den ersten Dateneingang eines Multiplexers sowie der Schaltungstakt auf den zweiten Eingang des ODER-Gatters gefuehrt. Der Ausgang des ODER-Gatters ist an den zweiten Dateneingang des Multiplexers gelegt, dessen Steuereingang ueber den ersten Eingang des Netzwerkes am Schaltungstaktunterdrueckungssignal angeschlossen ist. Der Datenausgang des Multiplexers realisert den Ausgang des Netzwerkes.

Dabei sind die einzelnen Ausgestaltungsvarianten der Flipflopanordnung und des nichtlinearen, die genannte logische Funktion ausfuehrenden Netzwerkes beliebig miteinander zur erfindungsgemaessen Anordnung kombinierbar.

Die Erfindung ermoeglicht den Entwurf der Schaltung nach Scan-path-Prinzipien und realisiert ein einfaches Steuerprinzip im "Testmodus". Die Flipflops sind frei waehlbar in beliebiger Reihenfolge zu einem oder mehreren Schieberegistern zusammenschaltbar.

In der gesamten Schaltung, eingeschlossen der Takterzeugungsschaltung, ist der Test der Stuck-open-Fehler durch Einstellbarkeit eines Initialisierungswertes und eines Testwertes moeglich, da innerhalb der erfindungsgemaessen Anordnung die gleichen Datenwege durchlaufen werden.

Die erfindungsgemaesse Loesung gestattet den Test von komplexen digitalen Schaltungen, ohne dass alle Taktsignale direkt ueber Schaltkreispins eingespeist werden muessen, indem die Ableitung mehrerer Taktsignale von einem Systemtakt gesteutzt wird. Weiterhin wird die Loesung des bei Verwendung mehrerer voneinander verschiedener Taktsignale auf einem Chip auftretenden Synchronisationsproblemes gesichert.

Der Test der Takterzeugungsschaltung erfolgt analog dem Test der uebrigen Schaltung.

Zum besseren Verstaendnis wird die Erfindung nunmehr anhand von Ausfuehrungsbeispielen und sieben Zeichnungen naeher erlaeutert.

Dabei zeigen:

Fig. 1       das Blockschaltbild der erfindungsgemaessen Anordnung

Fig. 2a       eine erste Ausfuehrung des nichtlinearen Netzwerkes

Fig. 2b       eine zweite Ausfuehrung des nichtlinearen Netzwerkes

Fig. 3a       die Flipflopanordnung als Master-Slave-Flipflop

Fig. 3b       die Flipflopanordnung als Master-Slave-Flipflop, geeignet fuer den Test von Stuck-open-Fehlern

Fig. 3c       die Flipflopanordnung als Latchanordnung

Fig. 3d       die Flipflopanordnung als Latchanordnung, geeignet fuer den Test von Stuck-open-Fehlern.

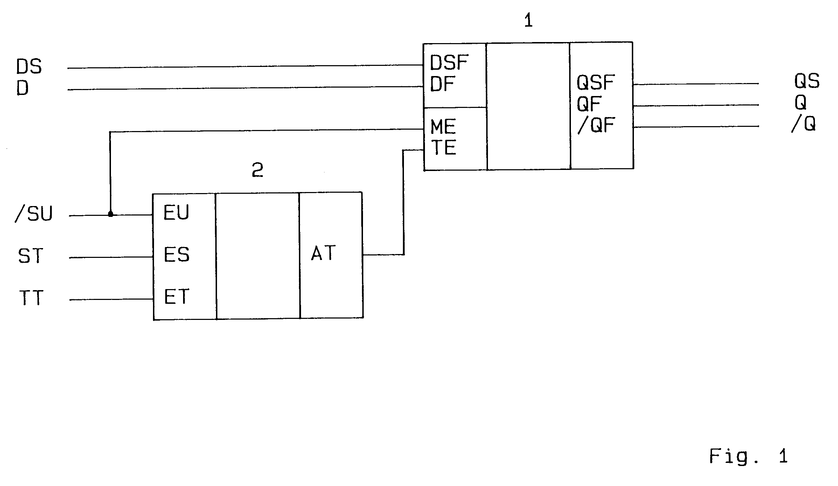

Wie in Fig. 1 dargestellt, besteht die erfindungsgemaesse Anordnung aus zwei Komponenten, einer Flipflopanordnung 1 und einem nichtlinearen, die logische Funktion T = ST * /SU + TT realisierenden Netzwerk 2 (im weiteren als Netzwerk 2 bezeichnet). Sie fuehrt einen Dateneingang D, einen Schiebedateneingang DS, einen Datenausgang Q, einen negierten Datenausgang /Q, einen Schiebedatenausgang QS und jeweils einen Eingang fuer einen Schaltungstakt ST, einen Testtakt TT und ein Schaltungstaktunterdrueckungssignal /SU.

Dabei sind der Dateneingang D der Anordnung auf den Dateneingang DF und der Schiebedateneingang DS auf den Schiebedateneingang DSF der Flipflopanordnung 1 gefuehrt. Der Datenausgang Q der erfindungsgemaessen Anordnung ist durch der Datenausgang QF der Flipflopanordnung 1, der negierte Datenausgang /Q durch den negierten Datenausgang /QF und der Schiebedatenausgang QS durch den Schiebedatenausgang QSF der Flipflopanordnung 1 realisiert.

Das Schaltungstaktunterdrueckungssignal /SU ist auf den ersten Eingang EU des Netzwerkes 2, der Schaltungstakt ST auf dessen zweiten Eingang ES und der Testtakt TT auf dessen dritten Eingang ET gelegt. Der Ausgang AT des Netzwerkes 2 fuehrt den generierten Steuertakt T und ist mit dem Takteingang TE der Flipflopanordnung 1 verbunden. Das Schaltungstaktunterdrueckungssignal /SU ist weiterhin am Modussteuereingang der Flipflopanordnung 1 angeschlossen.

Dei Arbeitsweise des Netzwerkes 2 wird durch folgendes Signalspiel beschrieben:

```
    EU  !  ES  :  ET  !   AT

    ------------------------------

     1  !   X  '   0  !  = ES

     X  !   X  :   1  !    1

     0  !   X  :   0  !    0          (X...beliebig).
```

Fuer die Funktionsweise der Schaltung werden zwei Moden unterschieden, der "Anwendermodus" und der "Testmodus". Im "Anwendermodus" hat das Schaltungstaktunterdrueckungssignal /SU den Wert "1" und der Testtakt TT konstant "0". Am Takteingang TE der Flipflopanordnung 1 liegt damit der Schaltungstakt ST an.

Im "Testmodus" sind drei Betriebsarten zu unterscheiden: der Schiebetakt, der Initialisierungstakt und der Arbeitstakt.

Im Schiebetakt ist /SU = 0. Unabhaengig von Schaltungstakt ST liegt am Takteingang TE der Flipflopanordnung 1 der Testtakt TT.

Im Initialisierungstakt werden zwei Taktphasen unter schieden. In der ersten Taktphase sind /SU = TT = 1. Damit liegt am Takteingang TE ebenfalls "1". In der zweiten Taktphase sind /SU = TT = 0 und an TE liegt "0".

Im Arbeitstakt ist /SU = 1. Es werden wiederum zwei Taktphasen unterschieden. In der ersten Taktphase ist TT = 1. Damit liegt am Takteingang TE der Flipflopanordnung 1 unabhaengig vom Schaltungstakt ST der Wert "1". In der zweiten Taktphase ist TT = 0. Damit bestimmt der Schaltungstakt ST den Wert am Takteingang TE. Ist ST = 1, so bleibt am Takteingang TE der Wert "1" aus der ersten Taktphase erhalten. Ist ST = 0, so stellt sich auch am Takteingang TE der Wert "0" ein.

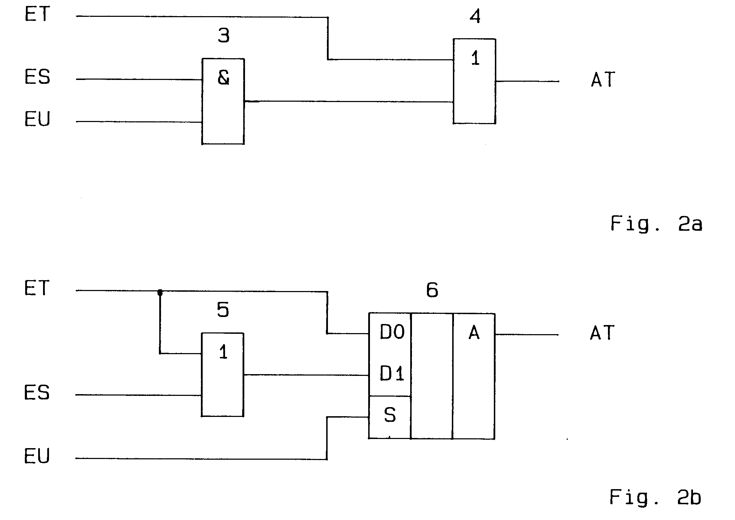

Eine erste Ausgestaltungsvariante des Netzwerkes 2 ist in Fig. 2a angegeben. Dabei sind der zweite Eingang ES des Netzwerkes 2 auf den ersten und der erste Eingang EU des Netzwerkes 2 auf den zweiten Eingang eines UND-Gatters 3 gefuehrt. Der Ausgang des UND-Gatters ist an den ersten Eingang eines ODER-Gatters gelegt, dessen zweiter Eingang an dritten Eingang ET des Netzwerkes 2 angeschlossen ist und dessen Ausgang den Ausgang AT des Netzwerkes 2 realisiert.

Fig. 2b zeigt eine zweite Ausgestaltungsvariante des Netzwerkes 2. Hierbei ist der dritte Eingang ET des Netzwerkes 2 mit dem ersten Eingang eines ODER-Gatters 5 und dem ersten Dateneingang D0 eines Multiplexers 6 sowie der zweite Eingang ES des Netzwerkes 2 mit dem zweiten Eingang des ODER-Gatters 5 verbunden. Der Ausgang des ODER-Gatters 5 ist an den zweiten Dateneingang D1 des Multiplexers 6 gelegt, dessen Steuereingang S am ersten Eingang EU des Netzwerkes 2 angeschlossen ist. Der Ausgang A des Mutliplexers 6 realisiert den Ausgang AT des Netzwerkes 2.

Beide Ausgestaltungsvarianten des Netzwerkes 2 sind in ihrer Funktion identisch und realisieren die logische Verknuepfung AT = ES * EU + ET und damit entsprechend der Beschaltung des Netzwerkes 2 gemaess Fig. 1 die logische Verknuepfung T = ST * /SU + TT.

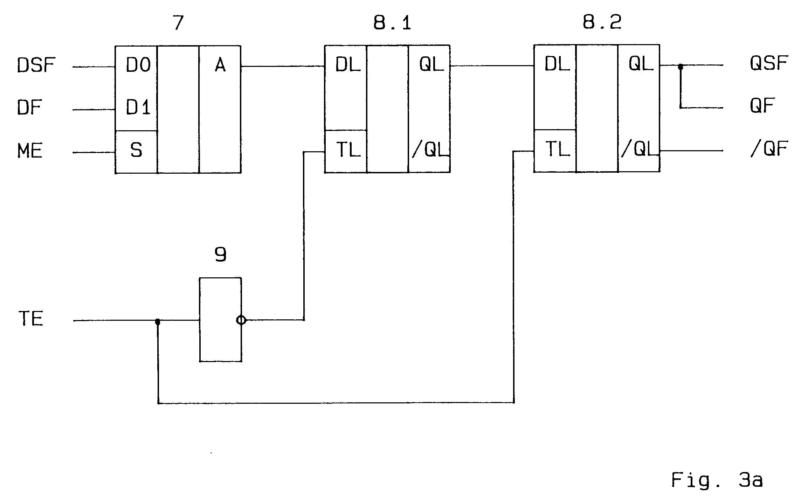

Fig. 3a zeigt die Flipflopanordnung 1 in einer ersten Ausgestaltungsvariante als scan-path-faehiges Master-Slave-Flipflop.

Dabei ist der Schiebedateneingang DSF der Flipflopanordnung 1 auf den ersten Dateneingang D0 und der Dateneingang DF der Flipflopanordnung 1 auf den zweiten Dateneingang D1 des Multiplexers 7 gefuehrt. Dessen Steuereingang S ist am Modussteuereingang ME der Flipflopanordnung 1 und ueber diesen am Schaltungstaktunterdrueckungssignal /SU angeschlossen. Sein Datenausgang A ist auf den Dateneingang DL des ersten Latches 8.1 gelegt. Der Takteingang TL des Latches 8.1 ist ueber einen Inverter 9 auf den Takteingang TE der Flipflopanordnung 1 gefuehrt. Sein Ausgang QL relisiert den Dateneingang DL des nachfolgenden Latches 8.2, dessen Takteingang TL nichtnegiert am Takteingang TE angeschlossen ist. Der Ausgang QL des zweiten Latches 8.2 ist auf den Schiebedatenausgang QSF und den Datenausgang QF der Flipflopanordnung 1 sowie der negierte Datenausgang /QL des Latches 8.2 auf den negierten Datenausgang /QF gefuehrt.

Im folgenden sei die Funktionsweise der Flipflopanordnung 1 gemaess Fig. 3a erlaeutert.

Hierbei hat der Multiplexer 7 folgende Arbeitsweise: Fuehrt sein Steuereingang S den Wert "0", so wird der Wert des Dateneinganges D0 an den Datenausgang A geschaltet. Liegt der Steuereingang S auf "1", so wird der Wert des Dateneinganges D1 an den Datenausgang A geschaltet. Die Arbeitsweise der Latches 8.i ist folgende: Fuehrt der Takteingang TL den Wert "1", so wird der am Dateneingang DL liegende Wert wahr an den Datenausgang QL und invertiert an den negierten Datenausgang /DL geschaltet. Das Latch uebernimmt Daten. Hat der Takteingang TL den Wert "0", wird der am Dateneingang DL liegende Wert nicht in das Latch 8.i uebernommen; das Latch speichert. Der Wert am Datenausgang QL und der am negierten Datenausgang /QL bleiben unveraendert.

Im "Anwendermodus" fuehrt der Modussteuereingang ME den Wert "1". In einer ersten Taktphase liegt am Takteingang TE der Wert "1" an. Das Latch 8.1 speichert seinen Zustand. Das Latch 8.2 uebernimmt den Zustand vom Latch 8.1 und schaltet ihn auf den Schiebedatenausgang QSF, den Datenausgang QF und invertiert auf den negierten Datenausgang /QF durch. In einer zweiten Taktphase hat der Takteingang TE den Wert "0". Das Latch 8.1 uebernimmt wegen ME = 1 den am Dateneingang DF anliegenden Wert. Latch 8.2 speichert seinen Zustand; an den Ausgaengen QSF, QF, /QF ergeben sich kein Aenderungen.

Im "Testmodus" sind Schiebetakt und Arbeitstakt auszufuehren. Diese unterscheiden sich dabei nur in ihrer zweiten Taktphase; ihre erste Taktphase entspricht der ersten Taktphase des "Anwendermodus". Im Schiebetakt fuehrt der Modussteuereingang ME den Wert "0", im Arbeitstakt den Wert "1". In der zweiten Taktphase des Schiebetaktes uebernimmt das Latch 8.1 Daten ueber den Schiebedateneingang DSF; die Werte an den Ausgaengen QSF, QF, /QF aendern sich nicht. In der zweiten Taktphase des Arbeitstaktes sind zwei Faelle zu unterscheiden. Im ersten Fall behaelt der Takteingang TE den Wert "1". Damit ergeben sich zur ersten Taktphase keine Aenderungen. Im zweiten Fall nimmt der Takteingang TE den Wert "0" an. Latch 8.1 uebernimmt jetzt Daten von Dateneingang DF wie in der zweiten Taktphase des "Anwendermodus".

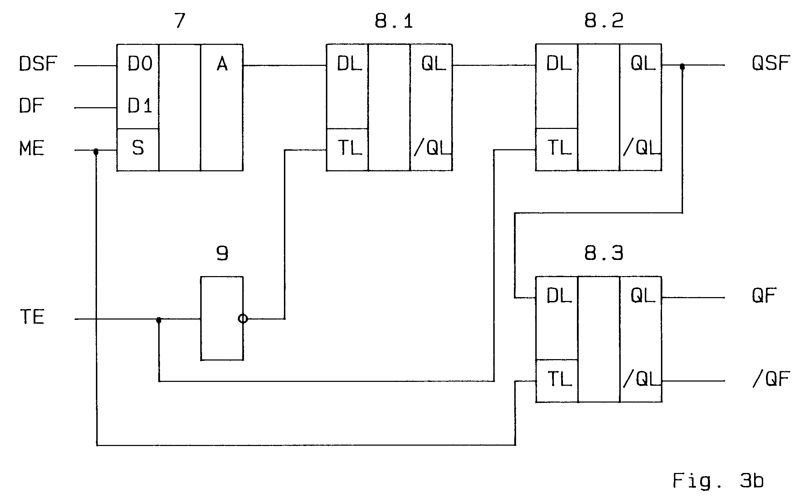

In Fig. 3b ist die Flipflopanordnung 1 in einer zweiten Ausgestaltungsvariante als scan-path-faehiges Master-Slave-Flipflop, konfiguriert fuer den Test von Stuck-open-Fehlern, dargestellt.

Hierbei ist der Schiebedateneingang DSF der Flipflopanordnung 1 auf den ersten Dateneingang D0 und der Dateneingang DF der Flipflopanordnung 1 auf den zweiten Dateneingang D1 des Multiplexers 7 gefuehrt. Dessen Steuereingang S ist am Modussteuereingang ME der Flipflopanordnung 1 angeschlossen. Sein Datenausgang A ist auf den Dateneingang DL des ersten Latches 8.1 gelegt. Der Takteingang TL des Latches 8.1 ist ueber einen Inverter 9 auf den Takteingang TE der Flipflopanordnung 1 gefuehrt. Sein Ausgang QL realisiert den Dateneingang DL des nachfolgenden Latches 8.2, dessen Takteingang TL nichtnegiert am Takteingang TE angeschlossen ist. Der Ausgang QL des zweiten Latches 8.2 ist auf den Schiebedatenausgang QSF und den Dateneingang DL des dritten Latches 8.3 gefuehrt, dessen Takteingang TL am Modussteuereingang ME der Flipflopanordnung 1 liegt. Der Ausgang QL des Latches 8.3 realisiert den Datenausgang QF, sein negierter Datenausgang /QL den Datenausgang /QF der Flipflopanordnung 1.

Die Funktionsweise dieser Ausgestaltungsvariante unterscheidet sich von der nach Fig. 3a ausgefuehrten wie folgt:

Da am Modussteuereingang ME im Schiebetakt der Wert "0" liegt, sichert das zusaetzliche Latch 8.3 den Datenerhalt an den Datenausgaengen QF und /QF.

Um den Test auf Stuck-open-Fehler zu ermoeglichen, muss ein Initialisierungswert in Latch 8.3 eingeschoben werden. Dazu dient der Initialisierungstakt im Testmodus. In seiner ersten Taktphase fuehren Modussteuereingang ME und Takteingang TE den Wert "1". Im Unterschied zur ersten Taktphase des Schiebetaktes uebernimmt das Latch 8.3 den im vorangegangenen Schiebetakt in Latch 8.1 eingespeicherten Initialisierungswert ueber Latch 8.2. Der Initialisierungswert liegt dann entsprechend an den Datenausgaengen QF und /QF an, bis in einem Arbeitstakt der eigentliche Testwert das Latch 8.3 auf dem gleichen Datenweg erreicht und durchlaeuft.

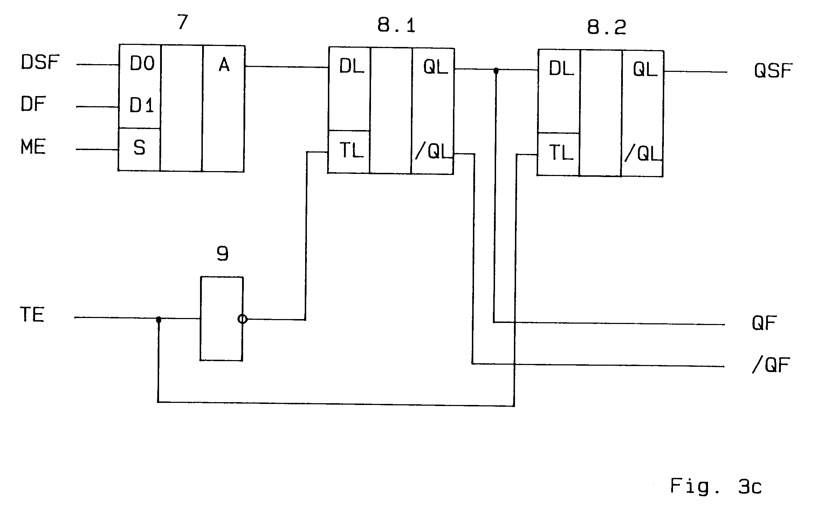

Fig. 3c zeigt die Flipflopanordnung 1 in einer dritten Ausgestaltungsvariante als scan-path-faehige Latchanordnung.

Diese unterscheidet sich von der ersten Ausgestaltungsvariante nach Fig. 3a dadurch, dass der Datenausgang QF der Flipflopanordnung 1 nicht am Datenausgang QL des Latches 8.2, sondern an dem des Latches 8.1 und der negierte Datenausgang /QF aequivalent nicht am negierten Datenausgang /QL des Latches 8.2, sondern ebenfalls an dem des Latches 8.1 angeschlossen sind.

Damit ergibt sich folgende Funktionsweise:

Im "Anwendermodus" liegt am Modussteuereingang ME der Wert "1". In einer ersten Taktphase fuehrt der Takteingang TE ebenfalls den Wert "1". Latch 8.1 speichert seinen Zustand; die Werte der Datenausgaenge QF und /QF bleiben konstant. Latch 8.2 uebernimmt den Zustand von Latch 8.1 und schaltet ihn auf den Schiebedatenausgang QSF durch. In einer zweiten Taktphase liegt am Takteingang TE der Wert "0" an. Latch 8.1 uebernimmt, da ME = 1, den am Dateneingang DF anliegenden Wert und schaltet ihn auf den Datenausgang QF sowie invertiert auf den negierten Datenausgang /QF durch. Das Latch 8.2 speichert seinen Zustand; am Schiebedatenausgang QSF tritt keine Veraenderung ein.

Im "Testmodus" sind Schiebetakt und Arbeitstakt auszufuehren. Diese unterscheiden sich wiederum nur in ihrer zweiten Taktphase; ihre erste Taktphase entspricht der ersten Taktphase des "Anwendermodus". Im Schiebetakt fuehrt der Modussteuereingang ME den Wert "0", im Arbeitstakt den Wert "1". In der zweiten Taktphase des Schiebetaktes uebernimmt das Latch 8.1 den Wert an Schiebedateneingang DSF und schaltet ihn auf den Datenausgang QF und invertiert auf den negierten Datenausgang /QF; der Wert am Schiebedatenausgang aendert sich nicht. In der zweiten Taktphase des Arbeitstaktes sind wiederum zwei Faelle zu unterscheiden. Im ersten Fall behaelt der Takteingang TE den Wert "1". Damit aendert sich gegenueber der ersten Taktphase nichts. Im zweiten Fall nimmt der Takteingang TE den Wert "0" an. Latch 8.1 uebernimmt Daten vom Dateneingang DF, die auf die Ausgaenge QF und /QF durchgeschaltet werden. Am Schiebedatenausgang QSF kommt es zu keiner Veraenderung.

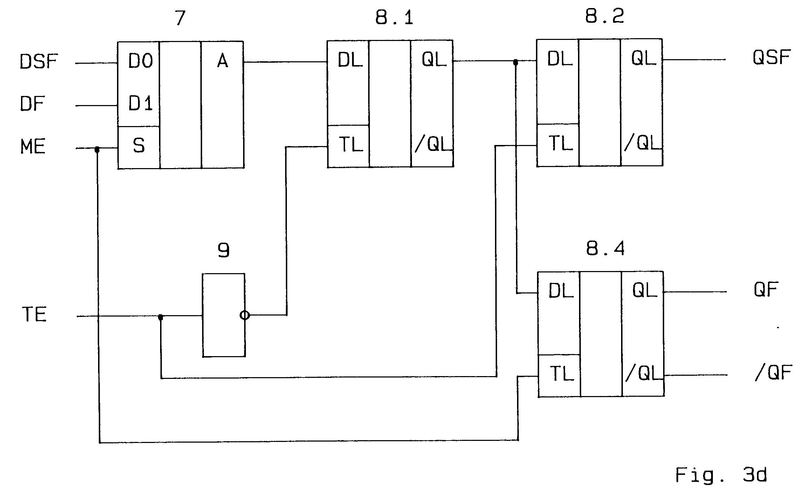

Bei der in Fig. 3d dargestellten Flipflopanordnung 1 handelt es sich um eine scan-path-faehige Latchanordnung, konfiguriert fuer den Test von Stuck-open-Fehlern.

Dabei ist der Schiebedateneingang DSF der Flipflopanordnung 1 auf den ersten Dateneingang D0 und der Dateneingang DF der Flipflopanordnung 1 auf den zweiten Dateineingang D1 des Multiplexers 7 gefuehrt. Dessen Steuereingang S ist am Modussteuereingang ME der Flipflopanordnung 1 und ueber diesen am Schaltungstaktunterdrueckungssignal /SU angeschlossen. Sein Datenausgang A ist auf den Dateneingang DL des ersten Latches 8.1 gelegt. Der Takteingang TL des Latches 8.1 ist ueber einen Inverter 9 auf den Takteingang TE der Flipflopanordnung 1 gefuehrt. Sein Ausgang QL relisiert den Dateneingang DL des nachfolgenden Latches 8.2, dessen Takteingang TL wiederum nichtnegiert am Takteingang TE angeschlossen ist, sowie den Dateneingang DL eines zusaetzlichen dritten Latches 8.4, dessen Takteingang am Modussteuereingang ME der Flipflopanordnung 1 liegt. Der Ausgang QL des zweiten Latches 8.2 ist auf den Schiebedatenausgang QSF, der Datenausgang QL des dritten Latches 8.4 auf den Datenausgang QF und der negierte Datenausgang /QL des Latches 8.4 auf den negierten Datenausgang /QF der Flipflopanordnung 1 gefuehrt.

6

Die Funktionsweise der vierten Ausgestaltungsvariante unterscheidet sich von der nach Fig. 3c ausgefuehrten wie folgt:

Da das Modussteuersignal ME im Schiebetakt den Wert "0" besitzt, sichert die zusaetzliche Latchzelle 8.4 den Datenerhalt an den Datenausgaengen QF und /QF. Um den Test auf Stuck-open-Fehler zu ermoeglichen, ist wieder ein Initialisierungtakt im "Testmodus" enthalten, in welchem ein Initialisierungswert in das Latch 8.4 eingeschoben wird.

In der ersten Taktphase des Initialisierungstaktes liegt am Modussteuereingang ME und am Takteingang TE der Wert "1". Im Unterschied zur ersten Taktphase des Schiebetaktes uebernimmt das Latch 8.4 den im vorangegangenen Schiebetakt in das Latch 8.1 eingespeicherten Initialisierungswert, der dann entsprechend an den Datenausgaengen QF und /QF anliegt, bis in einem Arbeitstakt der eingentliche Testwert das Latch 8.4 auf dem gleichen Datenweg erreicht und durchlaeuft.

Der Test des Schaltungstaktes ST und der ihn ableitenden Taktschaltung erfolgt in der zweiten Taktphase des Arbeitstaktes im "Testmodus".

Wird eine Taktschaltung zur Ableitung des Schaltungstaktes ST verwendet, so ist bei ihrer Realisierung ueber scan-path-faehige Master-Slave-Flipflops entsprechend den Fig. 3a und 3b gewaehrleistet, dass die Flipflops der Taktschaltung, wenn sie zum Test des Schaltungstaktes ST benutzt werden, waehrend der zweiten Taktphase des Arbeitstaktes bei zusaetzlicher Einstellung des Wertes "1" am Eingang ES des Netzwerkes 2 den eingestellten Zustand behalten.

Die Einstellung des Schaltungstaktes ST fuer die Flipflops ausserhalb der Taktschaltung erfolgt durch Einschieben im Schiebetakt des "Testmodus".

Wird keine Taktschaltung zur Ableitung des Schaltungstaktes ST verwendet, so erfolgt im einfachsten Fall die Einstellung des Schaltungstaktes ST durch die Verwendung eines direkt ueber ein Pin eingespeisten Grundtaktes als Schaltungstakt ST.

Im Schiebetakt wird in das Latch 8.1 ein bestimmter Wert ueber den Schiebedateneingang DS eingeschoben. Am Dateneingang D wird der dazu inverse Wert eingestellt. Wird nun der Wert "1" fuer den Schaltungstakt ST vorgegeben, so speichert das Latch 8.1 in der zweiten Taktphase des Arbeitstaktes seinen Zustand; der eingeschobene Wert aendert sich nicht. Wird der Wert "0" fuer den Schaltungstakt ST eingestellt, so uebernimmt das Latch 8.1 den Wert vom Dateneingang D. Der zuvor eingeschobene Wert wird damit vom inversen Wert ueberschrieben.

Die einzelnen Ausgestaltungsvarianten der Flipflopanordnung 1 nach den Fig. 3a; 3b; 3c; 3d und des Netzwerkes 2 nach den Fig. 2a und 2b sind beliebig miteinander zur erfindungsgemaessen Anordnung kombinierbar.

## Patentansprüche

1. Anordnung zum Test digitaler Schaltungen mit konfigurierbaren, in den Test einbezogenen Takterzeugungsschaltungen, mit einem Dateneingang (D) und einem Schiebedateneingang (DS), Datenausgängen (Q;/Q) und einem Schiebedatenausgang (QS) sowie Taktsignaleingängen (ST;TT) und einem Steuersignaleingang (/SU), enthaltend eine Flipflopanordnung (1) aus mindestens zwei und maximal drei getakteten, seriell verschalteten Latches (8), dergestalt, daß der Datenausgang (QL) der Latches (8) jeweils auf den Pateneingang (DL) der nachfolgenden Latches (8) geführt ist und daß dem Dateneingang (DL) des ersten Latches (8.1) ein Multiplexer (7) vorgeschaltet ist, dessen Dateneingänge (D1;D0) an dem Dateneingang (D) und dem Schiehedateneingang (DS) der Anordnung angeschlossen sind, dadurch gekennzeichnet, daß ein Schaltungstakt (ST), ein Testtakt (TT) und ein Schaltungstaktunterdrückungssignal (/SU) auf die entsprechenden Eingänge (ES; ET; EU) eines nichtlinearen, diese Signale logisch verknüpfenden Netzwerkes (2) geführt sind, an dessen Ausgang (AT) der generierte Steuertakt (T) gelegt ist, daß des Schaltungstaktunterdrückungssignel (/SU) auf den Steuereingang (S) des Multiplexers (7) geführt ist, daß der Takteingang (TL) des ersten Latches (8.1) negiert und der Takteingang (TL) das zweiten Latches (8.2) nichtnegiert am Steuertakt (T) sowie der Takteingang (TL) des dritten Latches (8.3) bei dessen Vorhandensein am Schaltungstaktunterdrückungssignal (/SU) angeschlossen sind und daß bestimmte Datanausgänge (QL;/QL) der genannten Latches (8.1;8.2;...) die Datenausgänge (Q;/Q) und den Schiebedatenausgang (QS) der Anordnung realisieren.

2. Anordnung nach Anspruch 1, dadurch gekennzeichnet, daß die Flipflopanordnung (1) vorzugsweise zwei seriell verschaltete Latches (8.1;8.2) enthält und daß der Datenausgang (Q) und der Schiebedatenausgang (QS) der Anordnung am Pateneusgang (QL) des zweiten Latches (8.2) sowie der negierte Datenausgang (/Q) der Anordnung am negierten Dateneusgang (/QL) des zweiten Latches (8.2) angeschlossen sind.

**3.** Anordnung nach Anspruch 1, dadurch gekennzeichnet, dass die Flipflopanordnung (1) vorzugsweise drei seriell verschaltete Latches (8.1;8.2;8.3) enthaelt und dass der Schiebedatenausgang (QS) der Anordnung am Datenausgang (QL) des zweiten Latches (8.2), der Datenausgang (Q) der Anordnung am Datenausgang (QL) des dritten Latches (8.3) sowie der negierte Datenausgang (/Q) der Anordnung am negierten Datenausgang (/QL) des dritten Latches (8.3) angeschlossen sind.

**4.** Anordnung nach Anspruch 1, dadurch gekennzeichnet, dass die Flipflopanordnung (1) vorzugsweise zwei seriell verschaltete Latches (8.1;8.2) enthaelt und dass der Schiebedatenausgang (QS) der Anordnung am Datenausgang (QL) des zweiten Latches (8.2), der Datenausgang (Q) der Anordnung am Datenausgang (QL) des ersten Latches (8.1) sowie der negierte Datenausgang (/Q) der Anordnung am negierten Datenausgang (/QL) des ersten Latches (8.1) angeschlossen sind.

**5.** Anordnung nach Anspruch 1, dadurch gekennzeichnet, dass die Flipflopanordnung (1) vorzugsweise zwei seriell verschaltete Latches (8.1;8.2) enthaelt, dass der Datenausgang (QL) des ersten Latches (8.1) zusaetzlich auf den Dateneingang (DL) eines dritten Latches (8.4), dessen Takteingang (TL) am Schaltungstaktunterdrueckungssignal (/SU) liegt, gefuehrt ist und dass der Schiebedatenausgang (QS) der Anordnung am Datenausgang (QL) des zweiten Latches (8.2), der Datenausgang (Q) der Anordnung am Datenausgang (QL) des dritten Latches (8.4) sowie der negierte Datenausgang (/Q) der Anordnung am negierten Datenausgang (/QL) des dritten Latches (8.4) angeschlossen sind.

**6.** Anordnung nach einem der vorhergehenden Ansprueche, dadurch gekennzeichnet, dass das nichtlineare Netzwerk (2) die logische Funktion T = ST * /SU + TT realisiert.

**7.** Anordnung nach Anspruch 6, dadurch gekennzeichnet, dass der Schaltungstakt (ST) ueber den Eingang (ES) des Netzwerkes (2) auf den ersten und das Schaltungstaktunterdrueckungssignal (/SU) ueber den Eingang (EU) des Netzwerkes (2) auf den zweiten Eingang eines UND-Gatters (3) gefuehrt sind, dass der Ausgang des UND-Gatters (3) an den ersten und der ueber den Eingang (ET) des Netzwerkes (2) angeschlosssene Testtakt (TT) an den zweiten Eingang eines ODER-Gatters (4) gelegt sind und dass der Ausgang des ODER-Gatters (4) den Ausgang (AT) des Netzwerkes (2) realisiert.

**8.** Anordnung nach Anspruch 6, dadurch gekennzeichnet, dass der Testtakt (TT) ueber den Eingang (ET) des Netzwerkes (2) auf den ersten Eingang eines ODER-Gatters (5) und den ersten Dateneingang (D0) eines Multiplexers (6) sowie der Schaltungstakt (ST) auf den zweiten Eingang des ODER-Gatters (5) gefuehrt sind, dass der Ausgang des ODER-Gatters (5) an den zweiten Dateneingang (D1) des Multiplexers (6) gelegt ist, dessen Steuereingang (S) ueber den Eingang (EU) des Netzwerkes (2) am Schaltungstaktunterdrueckungssignal (/SU) angeschlossen ist und dass der Datenausgang (A) des Multiplexers (6) den Ausgang (AT) des Netzwerkes (2) realisiert.

**Claims**

**1.** Device for testing digital circuits by means of adaptable clocking circuits included in the test, with a data input (D) and a shift data input (DS), data outputs (Q;/Q) and a shift data output (QS) as well as clock signal inputs (ST; TT) and a control signal input (/SU), containing a flip-flop device (1) of at least two and at most three serially connected latches (8) designed in such a way that the data output (QL) of the latches (8) in each case is led to the data input (DL) of the following latches (8) and that a multiplexer is connected preceding the data input (DL) of the first latch (8.1), the data inputs (D1;D0) of which being connected to the data input (D) and the shift data input (DS) of the device, characterized in that a circuit clock pulse (ST), a test clock pulse (TT) and a circuit clock pulse suppression signal (/SU) are led to the corresponding inputs (ES; ET; EU) of a non-linear network (2) which logically processes this signal, at whose output (AT) the generated control clock pulse (T) is provided, in that the circuit clock pulse suppression signal (/SU) is led to the control input (S) of the multiplexer (7), in that the clock pulse input (TL) of the first latch (8.1) negates ⟨sic. is negated⟩ and the clock pulse input (TL) of the second latch (8.2) non-negates ⟨sic. is non-negated⟩ connected to the control clock pulse (T) and the clock pulse input (TL) of the third latch (8.3), if present, are ⟨sic. is⟩ connected to the circuit clock pulse suppression signal (/SU), and in that certain data outputs (QL;/QL) of the said latches (8.1; 8.2; ...) represent the data outputs (Q;/Q) and the shift data output (QS) of the device.

**2.** Device according to claim 1, characterized in that the flip-flop device contains preferably two serially connected latches (8.1; 8.2) and in that the data output (Q) and the shift data output (QS) of the device are connected to the data output (QL) of the second latch (8.2) and the negated data output (/QL) of the second latch (8.2).

**3.** Device according to claim 1, characterized in that the flip-flop device (1) contains preferably three serially connected latches (8.1; 8.2; 8.3) and in that the shift data output (QS) of the device is connected to the data output (QL) of the second latch (8.2), the data output (Q) of the device to the data output (QL) of the third latch (8.3) and the negated data output (/Q) of the device to the negated data output (/QL) of the third latch (8.3).

**4.** Device according to claim 1, characterized in that the flip-flop device (1) contains preferably two serially connected latches (8.1; 8.2) and in that the shift data output (QS) of the device is connected to the data output (QL) of the second latch (8.2), the data output (Q) of the device to the data output (QL) of the first latch (8.1) and the negated data output (/Q) of the device to the negated data output (/QL) of the device to the negated data output (/QL) of the first latch (8.1).

**5.** Device according to claim 1, characterized in that the flip-flop device (1) contains preferably two serially connected latches (8.1; 8.2), in that the data output (QL) of the first latch (8.1) is led additionally to the data input (DL) of a third latch (8.4) whose clock pulse input (TL) lies at the circuit clock pulse suppression signal (/SU), and in that the shift data output (QS) of the device is connected to the data output (QL) of the second latch (8.2), the data output (Q) of the device to the data output (QL) of the third latch (8.4) and the negated data output (/Q) of the device to the negated data output (/QL) of the third latch (8.4).

**6.** Device according to one of the preceding claims, characterized in that the non-linear network (2) implements the propositional function T = ST * /SU + TT.

**7.** Device according to claim 6, characterized in that the circuit clock pulse (ST) is led via the input (ES) of the network (2) to the first input and the circuit clock pulse suppression signal (/SU) via the input (EU) of the network (2) to the second input of an AND-circuit (3), and in that the output of the AND-circuit (3) are provided at the first input and the test clock pulse (TT), connected via the input (ET) of the network (2), at the second input of an OR-circuit (4), and in that the output of the OR-circuit (4) implements the output (AT) of the network (2).

**8.** Device according to claim 6, characterized in that the test clock pulse (TT) is led via the input (ET) of the network (2) to the input of an OR-circuit (5) and to the first data input (D0) of a multiplexer (6) and the circuit clock pulse (ST) to the second input of an OR-circuit (5), and in that the output of the OR-circuit (5) is provided at the second data input (D1) of the multiplexer (6), whose control input (S) is connected via the input (EU) of the network (2) to the circuit clock pulse suppression signal (/SU), and in that the data output (A) of the multiplexer (6) implements the output (AT) of the network (2).

**Revendications**

**1.** Dispositif de test de circuits numériques par des circuits rythmeurs adaptables inclus dans le test comportant une entrée de données (D) et une entrée de données à décalage (DS), des sorties de données (Q;/Q) et une sortie de données à décalage (QS) de même que des entrées de signaux de rythme (ST;TT) et une entrée de signaux de commande (/SU) contenant un montage flipflop (1) constitué d'au minimum 2 et d'au maximum 3 verrous (latches) (8) cadencés, branchés en série de telle manière que la sortie de données (QL) des verrous (8) soit respectivement amenée à l'entrée de données (DL) du verrou suivant (8) et qu'un multiplexeur (7) où les entrées de données (D1;D0) sont raccordées à l'entrée de données (D) et à l'entrée des données à décalage (DS) du montage soit intercalé avant l'avant l'entrée de données (DL) du premier verrou (8.1) caractérisé en ce qu'un cycle de couplage (ST), un cycle de test (TT) et un signal de suppression de cycle de couplage (/SU) sont amenés sur les entrées correspondantes (ES; ET; EU) d'un réseau (2) non linéaire combinant logiquement ces signaux à la sortie duquel (AT) le cycle de commande généré (T) est appliqué, que le signal de supression de cycle de couplage (/SU) est amené à l'entrée de commande (S) du multiplixeur (7), que l'entrée du cycle (TL) du premier verrou (8.1) inversé et l'entrée de cycle (TL) du second verrou (8.2) non inversé sont raccordées au cycle de commande (T) de même que l'entrée du cycle (TL) du troisième verrou (8.3) s'il est présent l'est au signal de suppression du cycle de couplage (/SU) et que des sorties de données déterminées (QL;QL) des verrous mentionnés (8.1;8,2;...) assurent les sorties de données (Q;/Q) et la sortie des données de décalage (QS) du dispositif.

2. Dispositif selon la revendication 1 caractérisé en ce que le dispositif flipflop (1) contient de préférence deux verrous branchés en série (8.1;8.2) et que la sortie de données (Q) et la sortie de données à décalage (QS) du dispositif sont raccordées à la sortie de données (QL) du second verrou (8.2) ainsi que la sortie de données logiquement inversée (/Q) du dispositif à la sortie de données logiquement inversée (/QL) du second verrou (8.2).

3. Dispositif selon la revendication 1 caractérisé en ce que le dispositif flipflop (1) contient de préférence trois verrous branchés en série (8.1; 8.2; 8.3) et que la sortie de données de décalage (QS) du dispositif est raccordée à la sortie de données (QL) du second verrou (8.2), la sortie de données (Q) du dispositif à la sortie de données (QL) du troisième verrou (8.3) de même que la sortie de données logiquement inversée (/Q) du dispositif à la sortie de données logiquement inversée (/QL) du troisième verrou (8.3).

4. Dispositif selon la revendication 1 caractérisé en ce que le dispositif flipflop (1) contient de préférence deux verrous branchés en série (8.1; 8.2) et que la sortie de données de décalage (QS) du dispositif est raccordée à la sortie de données (QL) du second verrou (8.2), la sortie de données (Q) du dispositif à la sortie de données (QL) du premier verrou (8.1) de même que la sortie de données logiquement inversée (/Q) du dispositif à la sortie de données logiquement inversée (/QL) du premier verrou (8.1).

5. Dispositif selon la revendication caractérisé en ce que le dispositif flipflop (1) contient de préférence deux verrous (8.1; 8.2) branchés en série, que la sortie de données (QL) du premier verrou (8.1) est amenée d'autre part sur l'entrée de données (DL) d'un troisième verrou (8.4) dont l'entrée de cycle (TL) est appliquée au signal de suppression de cycle de couplage (/SU) et que la sortie de données de décalage (QS) du dispositif est raccordée à la sortie de données (QL) du second verrou (8.2), la sortie de données (Q) du dispositif à la sortie de données (QL) du troisième verrou (8.4) de même que la sortie de données logiquement inversée (/Q) du dispositif à la sortie de données logiquement inversée (/QL) du troisième verrou (8.4).

6. Dispositif selon l'une des revendications précédentes caractérisé en ce que le réseau non linéaire (Z) assure la fonction logique T = ST * SU + TT.

7. Dispositif selon la revendication 6 caractérisé en ce que le cycle de couplage (ST) est amené par l'entrée (ES) du circuit (2) à la première entrée d'un circuit logique ET (AND-Gatter) et le signal de suppression de cycle de couplage (/SU) par l'intermédiaire de l'entrée (EU) du circuit (2) à la seconde entrée correspondante (3), que la sortie du circuit logique ET (3) est appliquée à la première entrée d'un circuit logique OU (4) et le cycle de test (TT) raccordé par l'entrée (ET) du circuit (2) à la seconde entrée correspondante et que la sortie du circuit logique OU (4) assure la sortie (AT) du circuit (2).

8. Dispositif selon la revendication 6 caractérisé en ce que le cycle de test (TT) est amené par l'entrée (ET) du circuit (2) à la première entrée d'un circuit logique OU (5) et à la première entrée de données (DO) d'un multiplexeur (6) de même que le cycle de couplage (ST) à la seconde entrée du circuit logique correspondant OU (5), que la sortie du circuit logique OU (5) est appliquée à la seconde entrée (D1) du multiplexeur (6) dont l'entrée de commande (8) est raccordée par l'entrée (EU) du circuit (2) au signal de suppression de cycle de couplage (/SU) et que la sortie (A) du multiplexeur (6) assure la sortie (AT) du circuit (2).

Fig. 1

ET

3

ES

&

EU

4

1

AT

Fig. 2a

ET

5

1

ES

EU

6

D0

D1

S

A

AT

Fig. 2b

EP 0 403 436 B1

Fig. 3a

Fig. 3b

Fig. 3c

EP 0 403 436 B1

Fig. 3d

EP 0 403 436 B1